# EUROPÄISCHE PATENTSCHRIFT

(11) **EP 3 414 769 B1**
(45) Veröffentlichungstag und Bekanntmachung des Hinweises auf die Patenterteilung: **29.04.2026**
(21) Anmeldenummer: 17705031.7
(22) Anmeldetag: 27.01.2017
(51) Int. Cl.: H01G 7/06, H01G 4/12, H01G 4/33, H01G 4/008, H10D 1/68

(54) **MIKROELEKTRONISCHE ELEKTRODENANORDNUNG**
MICRO-ELECTRONIC ELECTRODE ASSEMBLY
DISPOSITIF D'ÉLECTRODES MICROÉLECTRONIQUE

(30) Priorität: 12.02.2016 DE 102016102501
(43) Veröffentlichungstag der Anmeldung: 19.12.2018
(73) Patentinhaber: Technische Universität Darmstadt, 64289 Darmstadt (DE)
(72) Erfinder: RADETINAC, Aldin, 64347 Griesheim (DE); MANI, Arzhang, 12161 Berlin (DE); KOMISSINSKIY, Philipp, 64846 Groß-Zimmern (DE); ALFF, Lambert, 64285 Darmstadt (DE); NIKFALAZAR, Mohammad, 64293 Darmstadt (DE)
(74) Vertreter: Habermann Intellectual Property Partnerschaft von Patentanwälten mbB
(86) Internationale Anmeldenummer: PCT/EP2017/051837
(87) Internationale Veröffentlichungsnummer: WO 2017/137269

(56) Entgegenhaltungen:
- EP-A1- 2 784 041
- EP-A2- 1 675 162
- DE-A1- 4 421 007
- US-A1- 2015 228 408

## Beschreibung

Die Erfindung betrifft eine mikroelektronische Elektrodenanordnung mit einer auf einem Substrat angeordneten Elektrode, wobei die Elektrode eine Elektrodenschicht aus einem ersten Elektrodenmaterial aufweist, welches eine perowskitische oder von einem Perowskit abgeleitete Kristallstruktur aufweist, wobei die Elektrode eine von dem Substrat abgewandte funktionale Oberfläche aufweist, wobei das erste Elektrodenmaterial bei Kontakt mit sauerstoffhaltigen Verbindungen oxidierbar ist, wobei das erste Elektrodenmaterial eine Verbindung mit der Summenformel A_{1±x}B_{1±y}O_{3±z} oder A₁₊ₙBₙ(O₁₋ₐNₐ)₃ₙ₊₁ ist, wobei A mindestens eines der Elemente Ca, Sr oder Ba oder eine Mischung dieser Elemente ist, wobei B mindestens eines der Elemente V, Nb, Ta, Cr, Mo oder W oder eine Mischung dieser Elemente ist, und wobei die Wertzahlen x, y, z und a jeweils Werte zwischen 0 und 1 und die Wertezahl n Werte zwischen 1 und ∞ annehmen können, wobei die mikroelektronische Elektrodenanordnung eine die funktionale Oberfläche der Elektrode bedeckende Trennschicht aus einem Trennschichtmaterial aufweist, und wobei die Trennschicht eine die Eigenschaften der Elektrode verändernde Oxidation des Elektrodenmaterials im Bereich der funktionalen Oberfläche verhindert.

Derartige Elektrodenanordnungen sind aus der Praxis in vielfältigen Ausgestaltungen bekannt. Je nach gewünschter

Funktionalität oder Verwendung sind zahlreiche Halbleiterkomponenten mit unterschiedlichen Eigenschaften entwickelt worden, die aus verschiedenen Materialien bestehen oder zusammengesetzt werden können. Die Elektrode soll dabei regelmäßig eine möglichst hohe elektrische Leitfähigkeit aufweisen, nur einen geringen Raumbedarf haben und eine kostengünstige und zuverlässige Verbindung mit weiteren Schichten oder mikroelektronischen Komponenten ermöglichen.

Um mit einer derartigen Elektrodenanordnung einen Kondensator oder einen Varaktor herzustellen, kann die Elektrodenschicht beispielsweise aus einer Platinschicht bestehen, auf der eine Funktionsschicht aus einem geeigneten dielektrischen Material aufgebracht ist, dessen dielektrischen Eigenschaften während des Betriebs beeinflusst und verändert werden können. Auf dieser Funktionsschicht ist wiederum eine weitere, zweite Elektrode angeordnet, die ebenfalls aus Platin bestehen kann. Eine derartige Elektrodenanordnung mit mehreren Schichten ist beispielsweise in US 2015/0228408 A1 beschrieben. Ein solcher Kondensator kann mit üblichen Herstellungsverfahren kostengünstig hergestellt werden. Durch den polykristallinen Aufbau der Funktionsschicht bilden sich an den Grenzflächen und im Inneren der Funktionsschicht unvermeidbar Defekte und Korngrenzen, welche die Funktionalität der Funktionsschicht beeinträchtigen. Üblicherweise muss die Funktionsschicht deshalb ausreichend dick ausgebildet sein, um eine zuverlässige Funktionsweise und damit einen zuverlässigen Betrieb des Kondensators oder Varaktors zu ermöglichen. Mit zunehmender Schichtdicke der Funktionsschicht sind oftmals steigende Herstellungskosten und weniger günstige funktionale Eigenschaften wie beispielsweise Schaltzeiten und Energieeffizienz verbunden.

In EP 1 675 162 A2 ist eine Elektrodenanordnung beschrieben, bei der zwischen zwei Elektrodenschichten aus einem ersten Elektrodenmaterial eine Funktionsschicht aus einem Funktionsschichtmaterial angeordnet ist, wobei das erste Elektrodenmaterial eine perowskitische oder von einem Perowskit abgeleitete Kristallstruktur aufweist, und wobei die Funktionsschicht aus einem ferroelektrischen Material besteht.

Aus DE 44 21 007 A1 ist eine Elektrodenanordnung bekannt, bei der zwischen zwei Elektrodenschichten aus einem Elektrodenmaterial eine oder mehrere funktionelle Zwischenschichten angeordnet sind. Das erste Elektrodenmaterial kann eine perowskitische oder von einem Perowskit abgeleitete Kristallstruktur aufweisen. Die Zwischenschicht kann aus einem ferroelektrischen Perowskit bestehen.

Es wird als eine Aufgabe der vorliegenden Erfindung angesehen, eine Elektrodenanordnung der eingangs genannten Gattung so auszugestalten, dass auf der Elektrodenschicht aus dem Elektrodenmaterial eine Funktionsschicht mit vorteilhaften Eigenschaften angeordnet und zuverlässig mit der Elektrodenschicht aus dem Elektrodenmaterial verbunden werden kann.

Diese Aufgabe wird erfindungsgemäß für eine Elektrodenanordnung der eingangs genannten Gattung dadurch gelöst, dass auf der Trennschicht eine elektrisch isolierende Funktionsschicht angeordnet ist, dass auf der elektrisch isolierenden Funktionsschicht eine zweite Elektrode angeordnet ist, und dass die Trennschicht ein Trennschicht-Festkörpergitter und die Funktionsschicht ein Funktionsschicht-Festkörpergitter aufweist, wobei eine Gitterstruktur des Trennschicht-Festkörpergitters an eine Gitterstruktur des Funktionsschicht-Festkörpergitters angepasst ist, so dass die Funktionsschicht epitaktisch auf der Trennschicht aufgebracht werden kann.

Untersuchungen haben ergeben, dass ein eingangs genanntes erstes Elektrodenmaterial besonders vorteilhafte Eigenschaften für eine Elektrodenanordnung aufweist. Das Elektrodenmaterial weist eine sehr hohe Leitfähigkeit und eine sehr geringe Oberflächenrauigkeit auf. Durch die perowskitische oder von einem Perowskit abgeleitete Kristallgitterstruktur wird bei einer darauf angeordneten Funktionsschicht die Ausbildung einer vergleichbaren Kristallgitterstruktur begünstigt. Mit Hilfe von üblichen Epitaxie-Verfahren können sowohl die Schicht aus dem ersten Elektrodenmaterial als auch die Trennschicht und eine darauf angeordnete Funktionsschicht hergestellt werden. Vorzugsweise sind dabei das Elektrodenmaterial und das Trennschichtmaterial sowie die jeweiligen Schichtdicken so vorgegeben, dass die Trennschicht gitterangepasst auf der Elektrodenschicht so angeordnet bzw. aufgebracht werden kann, so dass eine räumliche Gitterstruktur der Trennschicht durch eine räumliche Gitterstruktur der Elektrodenschicht vorgegeben wird.

Da die derzeit als besonders geeignet identifizierten Elektrodenmaterialien bei Kontakt mit sauerstoffhaltigen Verbindungen sehr rasch oxidieren und dadurch von einer Randschicht aus die Zusammensetzung und Eigenschaften der Elektrodenschicht verändert würden, so dass die für die Elektrode vorteilhaften Eigenschaften beeinträchtigt und deren Funktionstüchtigkeit gefährdet wäre, ist eine die funktionale Oberfläche der Elektrode bedeckende Trennschicht vorgesehen, durch welche eine die Eigenschaften der Elektrode verändernde Oxidation des Elektrodenmaterials im Bereich der funktionalen Oberfläche verhindert wird. Die Trennschicht kann sehr dünn ausgebildet sein und eine Dicke von nur wenigen Nanometern aufweisen. Zudem weist die Trennschicht eine geeignete Kristallgitterstruktur auf, um eine darauf angeordnete Funktionsschicht ebenfalls mit einer geeigneten Kristallgitterstruktur auszubilden und mit einem Epitaxie-Verfahren herstellen zu können. Die geeigneten Elektrodenmaterialien oxidieren üblicherweise bereits bei Kontakt mit Luft und auch bei Kontakt mit anderen Materialien oder Beschichtungen, die sauerstoffhaltige Verbindungen aufweisen, so dass nach der Bedeckung der funktionalen Oberfläche der Elektrode mit der Trennschicht die noch unfertige Elektrodenanordnung ohne gesonderte Maßnahmen wie beispielsweise ein Vakuum gelagert und weiterbearbeitet werden kann. Dadurch vereinfacht sich die Herstellung einer erfindungsgemäßen Elektrodenanordnung erheblich, wodurch merkliche Kosteneinsparungen möglich werden.

Erfindungsgemäß ist vorgesehen, dass auf der Trennschicht eine elektrisch isolierende Funktionsschicht angeordnet ist, und dass auf der elektrisch isolierenden Funktionsschicht eine zweite Elektrode angeordnet ist. Auf diese Weise können beispielsweise Kondensatoren oder Varaktoren mit sehr geringer Dicke des jeweiligen Schichtenaufbaus und gleichzeitig mit für deren Betrieb sehr vorteilhaften Eigenschaften hergestellt werden. Die Funktionsschicht kann nahezu beliebige elektrische oder magnetische Eigenschaften aufweisen, um je nach Anforderung und Verwendungszweck der Elektrodenanordnung unterschiedliche Eigenschaften und Funktionen zu ermöglichen. Da die einzelnen Schichten sehr dünn ausgebildet sein können, wird zudem für die einzelnen Schichten nur eine geringe Menge des jeweiligen Materials benötigt, so dass eine rasche und kostengünstige Herstellung der einzelnen Materialschichten und des gesamten mikroelektronischen Bauteils bzw. der mikroelektronischen Elektrodenanordnung begünstigt wird.

Es hat sich gezeigt, dass erfindungsgemäß ein Varaktor mit vorteilhaften Eigenschaften dadurch hergestellt werden kann, dass die elektrisch isolierende Funktionsschicht veränderbare dielektrische Eigenschaften aufweist. Im Gegensatz zu bereits bekannten und herkömmlich hergestellten Varaktoren sind mit der erfindungsgemäßen Ausgestaltung der Elektrodenanordnung Varaktoren mit einer sehr dünnen Funktionsschicht aus einem besonders geeigneten dielektrischen Material möglich.

Die Herstellung und vorteilhafte Ausgestaltung der Funktionsschicht wird unter anderem dadurch begünstigt, dass die Trennschicht ein Trennschicht-Festkörpergitter und die Funktionsschicht ein Funktionsschicht-Festkörpergitter aufweisen, wobei eine Gitterstruktur des Trennschicht-Festkörpergitters an eine Gitterstruktur des Funktionsschicht-Festkörpergitters angepasst ist, so dass die Funktionsschicht epitaktisch auf der Trennschicht aufgebracht werden kann. In gleicher Weise kann das Trennschicht-Festkörpergitter an eine Gitterstruktur der Elektrodenschicht aus dem Elektrodenmaterial angepasst sein, so dass die Trennschicht epitaktisch auf der Elektrodenschicht aufgebracht werden kann und die dadurch bewirkte Gitterstruktur der Trennschicht an die Gitterstruktur der Elektrodenschicht angepasst ist, bzw. durch die Gitterstruktur der Elektrodenschicht vorgegeben wird.

Gemäß einer Ausgestaltung des Erfindungsgedankens ist vorgesehen, dass das erste Elektrodenmaterial ein perowskitisches Oxid, ein perowskitisches Oxinitrid oder eine perowskitbasierte Ruddlesden-Popper-Struktur ist. Es hat sich gezeigt, dass ein derartiges Elektrodenmaterial besonders vorteilhafte Eigenschaften aufweist und unter anderem bereits bei besonders geringen Schichtdicken eine hohe elektrische Leitfähigkeit aufweist. Es können außer perowskitischen Oxiden oder Oxinitriden auch andere Materialien verwendet werden, die eine perowskitbasierte Ruddlesden-Popper-Struktur aufweisen, durch die vergleichbare vorteilhafte Eigenschaften für das Elektrodenmaterial vorgegeben werden. Eine erfindungsgemäße perowskitbasierte Ruddlesden-Popper-Struktur weist einen mehrschichtigen Aufbau abwechselnder Schichten mit einer Perowskitstruktur und mit einer Natriumchlorid-Struktur auf.

Erfindungsgemäß ist vorgesehen, dass das erste Elektrodenmaterial eine Verbindung mit der Summenformel A_{1±x}B_{1±y}O_{3±z} oder A₁₊ₙBₙ₍O₁₋ₐNₐ)₃ₙ₊₁ ist, wobei A eines der Elemente Ca, Sr oder Ba oder eine Mischung dieser Elemente ist, wobei B eines der Elemente V, Nb, Ta, Cr, Mo oder W oder eine Mischung dieser Elemente ist, und wobei die Wertzahlen x, y, z und a jeweils Werte zwischen 0 und 1 und die Wertezahl n Werte zwischen 1 und ∞ annehmen können. Ein erfindungsgemäßes Elektrodenmaterial mit einer Ruddlesden-Popper-Struktur kann eine Verbindung mit der Summenformel Aₙ₊₁BO₃ₙ₊₁ aufweisen, wobei A eines der vorangehend als A bezeichneten Elemente und B eines der vorangehend als B bezeichneten Elemente sein kann und wobei der Index n auch die Anzahl der Perowskitschichten in der Ruddlesden-Popper-Struktur bezeichnet. Ein derartiges Elektrodenmaterial, welches kein perowskitisches Oxid oder Oxinitrid ist, sondern lediglich eine perowskitbasierte Ruddlesden-Popper-Struktur aufweist, kann ebenfalls für die Herstellung einer erfindungsgemäßen Elektrodenanordnung verwendet werden und weist bei einer geeigneten Materialwahl vergleichbare vorteilhafte Eigenschaften auf. Besonders vorzugsweise ist vorgesehen, dass das erste Elektrodenmaterial eine der Verbindungen SrMoO₃, SrMoO₃₋ₐNₐ BaMoO₃, SrVO₃, SrNbO₃ oder Sr₂MoO₄ aufweist. Die vorangehend genannten Elektrodenmaterialien weisen nicht nur für eine Verwendung als Elektrode auf einem Substrat gute Eigenschaften auf, sondern begünstigen auch die Ausbildung und Anhaftung einer Funktionsschicht aus vorteilhaften dielektrischen Materialien und mit vorteilhaften Eigenschaften.

Gemäß einer vorteilhaften Ausgestaltung des Erfindungsgedankens ist vorgesehen, dass das Elektrodenmaterial einen spezifischen Widerstand von weniger als 100 µΩm, vorzugsweise von weniger als 30 µΩm aufweist. Ein elektrisches Leitermaterial wird üblicherweise als ein Material mit einem spezifischen Widerstand von weniger als 1000 µΩm angesehen. Das erfindungsgemäß bevorzugte Elektrodenmaterial weist demgegenüber einen deutlich geringeren spezifischen Widerstand auf. Ein Elektrodenmaterial mit einem derart geringen spezifischen Widerstand ermöglicht eine hohe elektrische Leitfähigkeit des Elektrodenmaterials und eine vorteilhafte elektrische Anbindung der Elektrodenanordnung an weitere elektrische Komponenten wie beispielsweise eine Spannungsversorgung der Elektrode.

Erfindungsgemäß ist vorgesehen, dass die Trennschicht ein perowskitisches Oxid ist und eine Verbindung mit der Summenformel A_{1±x}B_{1±y}O_{3±z} aufweist, wobei entweder A eines der Elemente Ca, Sr oder Ba oder eine Mischung dieser Elemente und B eines der Elemente Ti, Zr oder Hf oder eine Mischung dieser Elemente ist, oder wobei A eines der Elemente La, Pr, Dy, Tb, Sm, Nd oder Gd oder eine Mischung dieser Elemente und B eines der Elemente Sc oder Y oder eine Mischung dieser Elemente ist, und wobei die Wertzahlen x, y und z jeweils Werte zwischen 0 und 1 annehmen können.

Gemäß einer besonders vorteilhaften Ausgestaltung des Erfindungsgedankens ist vorgesehen, dass die Trennschicht eine der Verbindungen SrTiO₃, SrZrO₃, DyScO₃, GdScO₃ oder SrHfO₃ aufweist. Es hat sich gezeigt, dass durch die Verwendung derartiger Verbindungen bereits Trennschichten mit einer sehr geringen Schichtdicke von wenigen Nanometern ausreichen können, um eine unerwünschte Reaktion der Schicht aus dem ersten Elektrodenmaterial mit Sauerstoff bzw. Sauerstoffverbindungen aus der Umgebung oder aus der darauf angeordneten Funktionsschicht zu verhindern. So ist beispielsweise eine Trennschicht aus SrTiO₃ mit einer Dicke von lediglich fünf oder etwa fünf Kristallgittereinheiten bzw. von wenigen Nanometern ausreichend, um das erste Elektrodenmaterial abzuschirmen. Gleichzeitig weist die Trennschicht eine Kristallgitterstruktur auf, die sowohl an die Kristallgitterstruktur des ersten Elektrodenmaterials als auch an die Kristallgitterstrukturen geeigneter Funktionsschichten angepasst ist und vorteilhafte Kombinationen eines ersten Elektrodenmaterials und eines Funktionsmaterials begünstigt bzw. ermöglicht.

Die Verwendung von Metalloxiden und insbesondere von Metalloxiden mit Molybdän für die Herstellung der ersten Elektrode auf dem Substrat bewirkt besonders vorteilhafte Eigenschaften. So können beispielsweise ein Metalloxid mit Molybdän in der Oxidationsstufe 6 als Substratmaterial mit einem Metalloxid mit Molybdän in der Oxidationsstufe 4 als erstes Elektrodenmaterial kombiniert werden. Das Substratmaterial weist eine sehr hohe elektrisch isolierende Wirkung auf, während das erste Elektrodenmaterial eine sehr hohe elektrische Leitfähigkeit aufweist. Die Kristallgitterstrukturen sind aneinander angepasst.

Für die Verwendung der erfindungsgemäßen Elektrodenanordnung als Kondensator oder Varaktor ist es besonders vorteilhaft, dass die Funktionsschicht eine Verbindung mit der Summenformel BaₓSr₁₋ₓTi_{1±y}O_{3+z}, beispielsweise Ba_{0,5}Sr_{0,5}TiO₃ ist, wobei die Wertezahlen x, y und z jeweils Werte zwischen 0 und 1 annehmen können.

Die erfindungsgemäße Elektrodenanordnung kann in Verbindung mit weiteren elektrischen Komponenten und als elektrisches Funktionselement besonders vorteilhafte Eigenschaften aufweisen, wenn eine Austrittsarbeit des Elektrodenmaterials und/oder eine Elektronenaffinität des Trennschichtmaterials einen möglichst großen Unterschied, insbesondere einen Unterschied von mehr als 1 eV zu einer Elektronenaffinität eines Funktionsmaterials der Funktionsschicht aufweist. Durch den erfindungsgemäßen Potentialunterschied zwischen der Elektrode und der Funktionsschicht kann insbesondere bei kleinen elektrischen Spannungsabfällen bzw. elektrischen Feldern eine elektronische Barriere erzeugt werden, wodurch entsprechend geringe Leckströme begünstigt werden. Durch einen möglichst großen Unterschied von beispielsweise 0,5 eV oder 1 eV wird in einem Übergangsbereich von der Elektrode zu der Funktionsschicht eine Verarmungszone für elektrisch geladene Teilchen erzeugt, die dazu beitragen kann, dass unerwünschte Leckströme bei einer Verwendung der erfindungsgemäßen Elektrodenanordnung in einem elektrischen Bauteil reduziert werden.

Wenn die Austrittsarbeit des Elektrodenmaterials bereits einen ausreichend großen Unterschied zu der Elektronenaffinität des Funktionsmaterials aufweist, kann als Trennschichtmaterial ein Material mit einer Elektronenaffinität gewählt werden, welches zumindest näherungsweise der Elektronenaffinität des Funktionsmaterials entspricht, um eine wirksame elektronische Barriere zu unterstützen. Falls jedoch die Austrittsarbeit des Elektrodenmaterials näherungsweise der Elektronenaffinität des Funktionsmaterials entspricht und deshalb zunächst keine wirksame elektronische Barriere entstehen würde, kann durch die Wahl eines geeigneten Trennschichtmaterials mit einer deutlich von der Austrittsarbeit des Elektrodenmaterials und von der Elektronenaffinität des Funktionsmaterials abweichenden Elektronenaffinität eine elektronische Barriere erzeugt werden, um beispielsweise die Leckströme zu reduzieren.

Erfindungsgemäß ist vorgesehen, dass die Elektrodenanordnung einen Varaktor bildet. Mit den vorangehend genannten Materialien kann ein Varaktor mit besonders vorteilhaften Eigenschaften wie beispielsweise einer geringen Dicke der gesamten Elektrodenanordnung wie auch der einzelnen Schichten und insbesondere der Funktionsschicht hergestellt werden. Der Varaktor kann mit einer geringen Steuerspannung betrieben werden, wobei während des Betriebs nur geringe elektrische Verluste auftreten und der Varaktor sehr effizient betrieben werden kann.

Es ist auch möglich, als Funktionsschicht eine dünne ferroelektrische Schicht zu verwenden, um eine ferroelektrische Speicherzelle zu bilden. Weiterhin stellt auch die Verwendung der erfindungsgemäßen Elektrodenanordnung als Feldeffekttransistor eine mögliche und als vorteilhaft erachtete Nutzung der Erfindung dar.

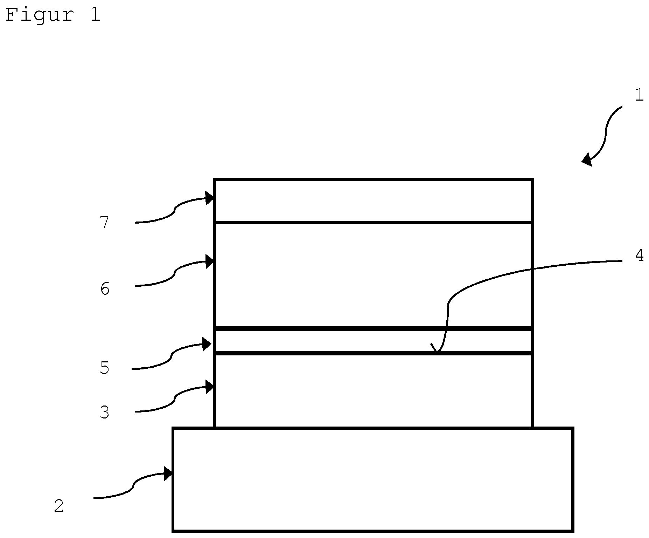

Nachfolgend wird ein Ausführungsbeispiel des Erfindungsgedankens näher beschrieben, was exemplarisch in der Abbildung gezeigt ist.

Die einzige Figur zeigt eine erfindungsgemäße Elektrodenanordnung 1. Auf einer Oberfläche eines Substrats 2 aus GdScO₃ ist eine erste Elektrode 3 angeordnet. Die erste Elektrode 3 besteht aus einer Schicht aus einem ersten Elektrodenmaterial SrMoO₃, das eine perowskitische Kristallgitterstruktur aufweist. Die erste Elektrode 3 weist eine dem Substrat 2 abgewandte funktionale Oberfläche 4 mit einer sehr geringen Oberflächenrauigkeit auf. Auf der funktionalen Oberfläche 4 der ersten Elektrode 3 ist eine nur wenige Nanometer dicke Trennschicht 5 aus SrTiO₃ aufgebracht. Die Trennschicht 5 verhindert eine Oxidation des ersten Elektrodenmaterials der ersten Elektrode 3 im Bereich der funktionalen Oberfläche 4.

Auf der von der Trennschicht 5 bedeckten funktionalen Oberfläche 4 der ersten Elektrode 3 ist eine Funktionsschicht 6 aus Ba_{0,5}Sr_{0,5}TiO₃ angeordnet. Die Funktionsschicht 6 besteht demzufolge aus einem dielektrischen Material, dessen dielektrischen Eigenschaften durch das Anlegen einer geeigneten Steuerspannung beeinflusst und gezielt verändert werden können. Auf der Funktionsschicht 6 ist eine zweite Elektrode 7 aus einem geeigneten Metall wie beispielsweise Silber, Gold oder Platin angeordnet.

Mit der exemplarisch in dem Ausführungsbeispiel dargestellten Elektrodenanordnung 1 wird ein Varaktor mit besonders vorteilhaften Eigenschaften gebildet. Die einzelnen Schichten der ersten Elektrode 3, der Trennschicht 5 und der Funktionsschicht 6 können mit geeigneten Epitaxie-Verfahren hergestellt werden, so dass die einzelnen Schichten jeweils geordnete Kristallgitterstrukturen aufweisen.

Die vorangehend aufgeführten Materialien für die einzelnen Schichten beinhalten Elemente mit Eigenschaften bezüglich der chemischen Potentiale (Elektronegativität), welche es selbst bei sehr geringen Schichtdicken erlauben, eine Trennung der thermodynamischen Potentiale zu erreichen. Zudem sind diese Materialien strukturell sehr ähnlich bzw. weisen eine nahezu identische Kristallstruktur auf, und erlauben damit eine epitaktische, hoch texturierte Aufbringung der einzelnen Schichten aufeinander. Die funktionale Einheit (erste Elektrode 3, Trennschicht 5 und Funktionsschicht 6) ergibt daher nur bei einer geeigneten Auswahl und Kombination der Materialien, angepassten Synthesebedingungen und bei ausreichend geringen Dicken der Trennschicht durch Epitaxie bzw. durch eine hohe Texturierung und vorwiegend gleich orientierte Körneranordnung der Schichten, vorteilhafte Eigenschaften bei einer uneingeschränkten Funktionalität der ersten Elektrodenschicht 3 und der Funktionsschicht 6.

Die in dem vorangehend beschriebenen Ausführungsbeispiel genannten Materialien stellen lediglich exemplarische Beispiele für geeignete Elektroden- und Funktionsmaterialien. Ein derartiger Schichtaufbau mit einem ersten Elektrodenmaterial SrMoO₃ für die erste Elektrode 3, mit einer Funktionsschicht 6 aus Ba_{0,5}Sr_{0,5}TiO₃ und mit einer beliebigen Metallelektrode für die Kontaktierung ergibt einen abstimmbaren Plattenkondensator, dessen Kapazität mittels einer statischen Bias-Spannung bzw. Steuerspannung vorgegeben werden kann. Der Vorteil in der Verwendung von dieses Elektrodenmaterials folgt aus der dadurch ermöglichten Epitaxie der Funktionsschicht 6, welche sehr dünne Funktionsschichten und deshalb vorteilhaft geringe Steuerspannungen, eine Ausrichtung der Struktur und deshalb eine vorteilhafte Begünstigung der Ansteuerung und eine geringe Defektdichte in der Funktionsschicht und deshalb geringe Leckströme ermöglicht. Im Vergleich dazu weisen herkömmliche Varaktoren aufgrund der polykristallin ausgebildeten Funktionsschicht weniger vorteilhafte Eigenschaften auf.

Die Trennschicht 5 ist dabei von maßgeblicher Bedeutung. Ein Varaktor, der mit denselben Materialien für die erste Elektrode 3 und die Funktionsschicht 6, jedoch ohne eine geeignete Trennschicht hergestellt würde, weist keine nennenswerten Varaktoreigenschaften auf, sondern verhält sich entweder schlecht leitend oder isolierend. Mit einer Trennschicht 5 beispielsweise aus SrTiO₃ kann ein erfindungsgemäßer Varaktor mit vorteilhaften Eigenschaften hergestellt werden. Durch die an die angrenzenden Schichten angepassten Abscheidebedingungen der Trennschicht 5 ist es möglich, das Elektrodenmaterial und das Funktionsmaterial räumlich und funktional zu trennen, sodass beide Materialien ihre jeweiligen Eigenschaften beibehalten.

Für die in der Figur exemplarisch dargestellte Elektrodenanordnung, die als Varaktor ausgebildet und betrieben werden kann (Varaktor 1), wurden einige relevante Eigenschaften ermittelt, die nachfolgend mit Daten aus einem Datenblatt zu einem kommerziell erhältlichen Varaktor "Parascan^{™}" STPTIC des Unternehmens Paratek Microwave, Inc. verglichen werden:

| | Parascan^{™} | Varaktor 1 |
|---|---|---|
| Kapazität | 1,20 pF | 5 pF |
| Leckstrom bei 20 V | 100 nA | < 100 nA |
| Abstimmbereich 2 V zu 20 V bei 100 kHz | 3,5 / 1 | 5 / 1 |
| Güte bei 900 MHz | 65 | 80 |
| Güte bei 1800 MHz | 45 | 50 |

Es hat sich gezeigt, dass der erfindungsgemäß ausgestaltete Varaktor 1 für die beabsichtigte Verwendung jeweils bessere Eigenschaften als ein vergleichbarer Varaktor mit einer herkömmlichen Bauweise aufweist, bei der metallische Elektroden mit einem polykristallinen Dielektrikum kombiniert sind. Die vorteilhaften Eigenschaften des erfindungsgemäßen Varaktors werden maßgeblich durch die oxidische untere Elektrode 3 mit dem epitaktisch aufgewachsenen Dielektrikum der Funktionsschicht 6 begünstigt. Auf diese Weise wird im Vergleich zu herkömmlichen Varaktoren eine wesentlich dünnere Funktionsschicht 6 ermöglicht, deren Kapazität durch Anlegen einer Spannung an den beiden Elektroden 3 und 7 gesteuert werden kann.

Ein weiteres zweites Ausführungsbeispiel entspricht im Wesentlichen dem vorangehend beschriebenen Ausführungsbeispiel. Zwischen der Austrittsarbeit des Elektrodenmaterials SrMoO₃ und der Elektronenaffinität des für die Funktionsschicht 6 verwendeten Funktionsmaterials Ba_{0,5}Sr_{0,5}TiO₃ besteht eine elektronische Barriere von etwa 0,2-0,6 eV. Bei dem zweiten Ausführungsbeispiel wird an Stelle des Trennschichtmaterials SrTiO₃ die Verbindung SrZrO₃ für die Trennschicht 5 verwendet. SrZrO₃ weist eine deutlich höhere Elektronenaffinität als das Funktionsmaterial Ba_{0,5}Sr_{0,5}TiO₃ auf, so dass die elektronische Barriere zwischen der Elektrode 3 und der Funktionsschicht 6 durch die vorteilhafte Wahl des Trennschichtmaterials SrZrO₃ begünstigt und verstärkt wird. Es hat sich gezeigt, dass vor diesem Hintergrund die Verwendung einer Verbindung mit der Summenformel SrXO3 vorteilhaft ist, wobei mit X eine beliebige Auswahl oder Mischung aus den Elementen Ti, Zr oder Hf bezeichnet ist.

Ein drittes Ausführungsbeispiel betrifft einen Varaktor 1 mit einer Elektrode 3 aus dem Elektrodenmaterial SrMoO₃, mit einer Trennschicht 5 aus dem Trennschichtmaterial SrTiO₃ und mit einer Funktionsschicht 6 aus einem Funktionsmaterial Ba_{0,5}Sr_{0,5}TiO₃. Durch die Verwendung eines epitaktischen Herstellungsverfahrens sind die Gitterstrukturen der Elektrode 3, der Trennschicht 5 und der Funktionsschicht 6 aneinander angepasst. Es kann deshalb eine weniger als 100 nm dicke und damit sehr dünne Funktionsschicht 6 auf der Trennschicht 5 aufgebracht werden, welche dennoch die gewünschte Funktionalität ermöglicht. Bei einem gemäß dem dritten Ausführungsbeispiel experimentell hergestellten Varaktor 1 konnten bei maximalen Steuerspannungen von weniger als 3,5 V Abstimmbarkeiten von mehr als 3/1 erreicht werden, so dass der in der voranstehenden Tabelle zum ersten Ausführungsbeispiel angegebene Abstimmbereich nicht hinsichtlich der Abstimmbarkeit von 3/1, sondern vor allem im Hinblick auf die hierfür notwendige Steuerspannung von weniger als 3,5 V anstelle von 20 V verändert und für viele Anwendungen verbessert ist. So können zahlreiche Komponenten von elektronischen Datenverarbeitungsgeräten mit einer Arbeitsspannung zwischen 3,5 V und 5 V versorgt werden, so dass ein Varaktor 1 gemäß dem dritten Ausführungsbeispiel als abstimmbares Bauteil in mobilen elektronischen Geräten wie z.B. Smartphones oder Smartwatches eingesetzt werden könnte, ohne aufwendige gesonderte Anforderungen an die in dem mobilen elektronischen Geräten verwendete Arbeitsspannung zu stellen.

## Patentansprüche

1. Mikroelektronische Elektrodenanordnung (1) mit einer auf einem Substrat (2) angeordneten ersten Elektrode (3), wobei die erste Elektrode (3) eine Elektrodenschicht aus einem ersten Elektrodenmaterial aufweist, welches eine perowskitische oder von einem Perowskit abgeleitete Kristallstruktur aufweist, wobei die Elektrode (3) eine von dem Substrat (2) abgewandte funktionale Oberfläche (4) aufweist, wobei das erste Elektrodenmaterial bei Kontakt mit sauerstoffhaltigen Verbindungen oxidierbar ist, wobei das erste Elektrodenmaterial eine Verbindung mit der Summenformel A_{1±x}B_{1±y}O_{3±z} oder A₁₊ₙBₙ(O₁₋ₐNₐ)₃ₙ₊₁ ist, wobei A mindestens eines der Elemente Ca, Sr oder Ba oder eine Mischung dieser Elemente ist, wobei B mindestens eines der Elemente V, Nb, Ta, Cr, Mo oder W oder eine Mischung dieser Elemente ist, und wobei die Wertzahlen x, y, z und a jeweils Werte zwischen 0 und 1 und die Wertezahl n Werte zwischen 1 und ∞ annehmen können, wobei die mikroelektronische Elektrodenanordnung eine die funktionale Oberfläche (4) der Elektrode (3) bedeckende Trennschicht (5) aus einem Trennschichtmaterial aufweist, und wobei die Trennschicht (5) eine die Eigenschaften der Elektrode (3) verändernde Oxidation des Elektrodenmaterials im Bereich der funktionalen Oberfläche (4) verhindert, wobei auf der Trennschicht (5) eine elektrisch isolierende Funktionsschicht (6) angeordnet ist, auf der elektrisch isolierenden Funktionsschicht (6) eine zweite Elektrode (7) angeordnet ist, und die Trennschicht (5) ein Trennschicht-Festkörpergitter und die Funktionsschicht (6) ein Funktionsschicht-Festkörpergitter aufweist, wobei eine Gitterstruktur des Trennschicht-Festkörpergitters an eine Gitterstruktur des Funktionsschicht-Festkörpergitters angepasst ist, so dass die Funktionsschicht (6) epitaktisch auf der Trennschicht (5) aufgebracht werden kann.

2. Elektrodenanordnung (1) nach Anspruch 1, **dadurch gekennzeichnet, dass** die elektrisch isolierende Funktionsschicht (6) veränderbare dielektrische Eigenschaften aufweist.

3. Elektrodenanordnung (1) nach einem der vorangehenden Ansprüche, **dadurch gekennzeichnet, dass** das erste Elektrodenmaterial ein perowskitisches Oxid, ein perowskitisches Oxinitrid oder eine perowskitbasierte Ruddlesden-Popper-Struktur ist.

4. Elektrodenanordnung (1) nach einem der vorangehenden Ansprüche, **dadurch gekennzeichnet, dass** das Elektrodenmaterial einen spezifischen Widerstand von weniger als 100 µΩm, vorzugsweise von weniger als 30 µΩm aufweist.

5. Elektrodenanordnung (1) nach einem der vorangehenden Ansprüche, **dadurch gekennzeichnet, dass** das erste Elektrodenmaterial eine der Verbindungen SrMoO₃, SrMoO₃₋ₐNₐ BaMoO₃, SrVO₃, SrNbO₃ oder Sr₂MoO₄ aufweist.

6. Elektrodenanordnung (1) nach einem der vorangehenden Ansprüche, **dadurch gekennzeichnet, dass** die Trennschicht (5) ein perowskitisches Oxid ist und eine Verbindung mit der Summenformel A_{1±x}B_{1±y}O_{3±z} aufweist, wobei entweder A eines der Elemente Ca, Sr oder Ba oder eine Mischung dieser Elemente und B eines der Elemente Ti, Zr oder Hf oder eine Mischung dieser Elemente ist, oder wobei A mindestens eines der Elemente La, Pr, Dy, Tb, Sm, Nd oder Gd oder eine Mischung dieser Elemente und B mindestens eines der Elemente Sc oder Y oder eine Mischung dieser Elemente ist, und wobei die Wertzahlen x, y und z jeweils Werte zwischen 0 und 1 annehmen können.

7. Elektrodenanordnung (1) nach Anspruch 6, **dadurch gekennzeichnet, dass** die Trennschicht (5) eine der Verbindungen SrTiO₃, SrZrO₃, DyScO₃, GdScO₃ oder SrHfO₃ aufweist.

8. Elektrodenanordnung (1) nach einem der vorangehenden Ansprüche, **dadurch gekennzeichnet, dass** die Funktionsschicht (6) eine Verbindung mit der Summenformel BaₓSr₁₋ₓTi_{1±y}O_{3±z}, vorzugsweise Ba_{0,5}Sr_{0,5}TiO₃ aufweist, wobei die Wertezahlen x, y und z jeweils Werte zwischen 0 und 1 annehmen können.

9. Elektrodenanordnung (1) nach einem der vorangehenden Ansprüche, **dadurch gekennzeichnet, dass** eine Austrittsarbeit des Elektrodenmaterials und/oder eine Elektronenaffinität des Trennschichtmaterials einen möglichst großen Unterschied, insbesondere einen Unterschied von mehr als 0,5 eV und vorzugsweise von mehr als 1 eV zu einer Elektronenaffinität eines Funktionsmaterials der Funktionsschicht aufweist.

10. Elektrodenanordnung (1) nach einem der vorangehenden Ansprüche, **dadurch gekennzeichnet, dass** die Elektrodenanordnung (1) einen Varaktor bildet.

## Claims

1. Microelectronic electrode arrangement (1) comprising a first electrode (3) arranged on a substrate (2), wherein the first electrode (3) has an electrode layer made of a first electrode material which has a perovskitic crystal structure or a crystal structure derived from a perovskite, wherein the electrode (3) has a functional surface (4) facing away from the substrate (2), wherein the first electrode material is oxidizable upon contact with oxygen-containing compounds, wherein the first electrode material is a compound having the empirical formula A_{1±x}B_{1±y}O_{3±z} or A₁₊ₙBₙ(O₁₋ₐNₐ)₃ₙ₊₁, wherein A is at least one of the elements Ca, Sr or Ba or a mixture of these elements, wherein B is at least one of the elements V, Nb, Ta, Cr, Mo or W or a mixture of these elements, and wherein the numerical values x, y, z and a can each assume values between 0 and 1 and the numerical value n can assume values between 1 and ∞, wherein the microelectronic electrode arrangement has a separating layer (5) made of a separating-layer material and covering the functional surface (4) of the electrode (3), and wherein the separating layer (5) prevents an oxidation of the electrode material in the region of the functional surface (4), which changes the properties of the electrode (3), wherein an electrically insulating functional layer (6) is arranged on the separating layer (5), a second electrode (7) is arranged on the electrically insulating functional layer (6), and the separating layer (5) has a separating-layer solid-state lattice and the functional layer (6) has a functional-layer solid-state lattice, wherein a lattice structure of the separating-layer solid-state lattice is adapted to a lattice structure of the functional-layer solid-state lattice, so that the functional layer (6) can be applied epitaxially on the separating layer (5).

2. Electrode arrangement (1) according to claim 1, **characterized in that** the electrically insulating functional layer (6) has variable dielectric properties.

3. Electrode arrangement (1) according to one of the preceding claims, **characterized in that** the first electrode material is a perovskitic oxide, a perovskitic oxynitride or a perovskite-based Ruddlesden-Popper structure.

4. Electrode arrangement (1) according to one of the preceding claims, **characterized in that** the electrode material has a specific resistance of less than 100 µOm, preferably of less than 30 µQm.

5. Electrode arrangement (1) according to one of the preceding claims, **characterized in that** the first electrode material comprises one of the compounds SrMoO₃, SrMoO₃₋ₐNₐ BaMoO₃, SrVO₃, SrNbO₃ or Sr₂MoO₄.

6. Electrode arrangement (1) according to one of the preceding claims, **characterized in that** the separating layer (5) is a perovskitic oxide and comprises a compound having the empirical formula A_{1±x}B_{1±y}O_{3±z}, wherein either A is one of the elements Ca, Sr or Ba or a mixture of these elements and B is one of the elements Ti, Zr or Hf or a mixture of these elements, or wherein A is at least one of the elements La, Pr, Dy, Tb, Sm, Nd or Gd or a mixture of these elements and B is at least one of the elements Sc or Y or a mixture of these elements, and wherein the numerical values x, y and z can each assume values between 0 and 1.

7. Electrode arrangement (1) according to claim 6, **characterized in that** the separating layer (5) comprises one of the compounds SrTiO₃, SrZrO₃, DyScO₃, GdScO₃ or SrHfO₃.

8. Electrode arrangement (1) according to one of the preceding claims, **characterized in that** the functional layer (6) comprises a compound having the empirical formula BaₓSr₁₋ₓTi_{1±y}O_{3±z}, preferably Ba_{0,5}Sr_{0,5}TiO₃, wherein the numerical values x, y and z can each assume values between 0 and 1.

9. Electrode arrangement (1) according to one of the preceding claims, **characterized in that** a work function of the electrode material and/or an electron affinity of the separating-layer material has as large a difference as possible, in particular a difference of more than 0.5 eV and preferably of more than 1 eV, from an electron affinity of a functional material of the functional layer.

10. Electrode arrangement (1) according to one of the preceding claims, **characterized in that** the electrode arrangement (1) forms a varactor.

## Revendications

1. Ensemble d'électrodes microélectronique (1) comprenant une première électrode (3) disposée sur un substrat (2), la première électrode (3) présentant une couche d'électrode constituée d'un premier matériau d'électrode qui présente une structure cristalline pérovskitique ou dérivée d'une pérovskite, l'électrode (3) présentant une surface fonctionnelle (4) tournée à l'opposé du substrat (2), le premier matériau d'électrode étant oxydable au contact de composés contenant de l'oxygène, le premier matériau d'électrode étant un composé de formule brute A_{1±x}B_{1±y}O_{3±z} ou A₁₊ₙBₙ(O₁₋ₐNₐ)₃ₙ₊₁, A étant au moins un des éléments Ca, Sr ou Ba ou un mélange de ces éléments, B étant au moins un des éléments V, Nb, Ta, Cr, Mo ou W ou un mélange de ces éléments, et les indices x, y, z et a pouvant chacun prendre des valeurs comprises entre 0 et 1 et l'indice n pouvant prendre des valeurs comprises entre 1 et ∞, l'ensemble d'électrodes microélectronique présentant une couche de séparation (5) constituée d'un matériau de couche de séparation et recouvrant la surface fonctionnelle (4) de l'électrode (3), et la couche de séparation (5) empêchant une oxydation du matériau d'électrode dans la région de la surface fonctionnelle (4), oxydation qui modifie les propriétés de l'électrode (3), une couche fonctionnelle électriquement isolante (6) étant disposée sur la couche de séparation (5), une seconde électrode (7) étant disposée sur la couche fonctionnelle électriquement isolante (6), et la couche de séparation (5) présentant un réseau cristallin solide de couche de séparation et la couche fonctionnelle (6) présentant un réseau cristallin solide de couche fonctionnelle, une structure de réseau du réseau cristallin solide de couche de séparation étant adaptée à une structure de réseau du réseau cristallin solide de couche fonctionnelle, de sorte que la couche fonctionnelle (6) peut être déposée de manière épitaxiale sur la couche de séparation (5).

2. Ensemble d'électrodes (1) selon la revendication 1, **caractérisé en ce que** la couche fonctionnelle électriquement isolante (6) présente des propriétés diélectriques variables.

3. Ensemble d'électrodes (1) selon l'une quelconque des revendications précédentes, **caractérisé en ce que** le premier matériau d'électrode est un oxyde pérovskitique, un oxynitrure pérovskitique ou une structure de Ruddlesden-Popper à base de pérovskite.

4. Ensemble d'électrodes (1) selon l'une quelconque des revendications précédentes, **caractérisé en ce que** le matériau d'électrode présente une résistivité spécifique inférieure à 100 µOm, de préférence inférieure à 30 µQm.

5. Ensemble d'électrodes (1) selon l'une quelconque des revendications précédentes, **caractérisé en ce que** le premier matériau d'électrode comprend l'un des composés SrMoO₃, SrMoO₃₋ₐNₐ BaMoO₃, SrVO₃, SrNbO₃ ou Sr₂MoO₄.

6. Ensemble d'électrodes (1) selon l'une quelconque des revendications précédentes, **caractérisé en ce que** la couche de séparation (5) est un oxyde pérovskitique et comprend un composé de formule brute A_{1±x}B_{1±y}O_{3±z}, où soit A est l'un des éléments Ca, Sr ou Ba ou un mélange de ces éléments et B est l'un des éléments Ti, Zr ou Hf ou un mélange de ces éléments, soit A est au moins un des éléments La, Pr, Dy, Tb, Sm, Nd ou Gd ou un mélange de ces éléments et B est au moins un des éléments Sc ou Y ou un mélange de ces éléments, et les indices x, y et z pouvant chacun prendre des valeurs comprises entre 0 et 1.

7. Ensemble d'électrodes (1) selon la revendication 6, **caractérisé en ce que** la couche de séparation (5) comprend l'un des composés SrTiO₃, SrZrO₃, DyScO₃, GdScO₃ ou SrHfO₃.

8. Ensemble d'électrodes (1) selon l'une quelconque des revendications précédentes, **caractérisé en ce que** la couche fonctionnelle (6) comprend un composé de formule brute BaxSr₁₋ₓTi_{1±y}O_{3±z}, de préférence Ba_{0,5}Sr_{0,5}TiO₃, les indices x, y et z pouvant chacun prendre des valeurs comprises entre 0 et 1.

9. Ensemble d'électrodes (1) selon l'une quelconque des revendications précédentes, **caractérisé en ce qu'**un travail de sortie du matériau d'électrode et/ou une affinité électronique du matériau de couche de séparation présente une différence aussi grande que possible, en particulier une différence de plus de 0,5 eV et de préférence de plus de 1 eV, par rapport à une affinité électronique d'un matériau fonctionnel de la couche fonctionnelle.

10. Ensemble d'électrodes (1) selon l'une quelconque des revendications précédentes, **caractérisé en ce que** l'ensemble d'électrodes (1) forme un varactor.
